(19) Europäisches Patentamt

European Patent Office

Office européen des brevets

(11) EP 0 945 980 A1

## (12) EUROPEAN PATENT APPLICATION

(43) Date of publication:
29.09.1999 Bulletin 1999/39

(51) Int. Cl.⁶: **H03J 1/00**, H03J 5/24, H03B 5/12

(21) Application number: 98105337.4

(22) Date of filing: 24.03.1998

(84) Designated Contracting States:
AT BE CH DE DK ES FI FR GB GR IE IT LI LU MC NL PT SE
Designated Extension States:
AL LT LV MK RO SI

(71) Applicant:
Sony International (Europe) GmbH
50829 Köln (DE)

(72) Inventor:
Ito, Koichi,
c/o Sony International (Europe) GMBH
85609 Aschheim (DE)

(74) Representative:
Körber, Martin, Dipl.-Phys. et al
Mitscherlich & Partner
Patentanwälte
Sonnenstrasse 33
80331 München (DE)

(54) **Band switchable tuning circuit**

(57) The present invention relates to a voltage controlled tuning circuit for tuning a resonance frequency of an oscillator, comprising a voltage controlled variable capacitance means (11;45), a first and second inductor means (12,13;46,47) connected in parallel to each other and parallel to the variable capacitance means (11;45), and a first band switch means (14;48) for the first inductor means (12;46) and a second band switch means (15;49) for the second inductor means (13;47) for band switching the resonance frequency. The tuning circuit according to the present invention is less sensible in view of the tolerances of its elements, so that the tuning of the resonance frequency is more precise. Further, the tuning circuit according to the present invention can be operated in the UHF- or VHF-band without the necessity of using expensive circuit elements.

Fig. 1

## Description

The present invention relates to a voltage controlled tuning circuit according to claim 1. The tuning circuit is band switchable between two or more frequency bands and is e.g. useful in a portable telephone of a mobile telecommunication system.

Voltage controlled tuning circuits which are band switchable between two different frequency bands are known from the state of the art, e.g. from DE 196 47 383 A1 and JP-A-07202638. DE 196 47 383 A1 and JP-A-09148888 disclose a voltage controlled tuning circuit and a resonance circuit. The voltage controlled tuning circuit is band switchable between two different frequency bands by means of a first and a second inductor means connected in series whereby a PIN diode is connected in parallel to the second inductor means. A variable capacitance means is connected in parallel to the first and the second inductor means. The variable capacitance means is voltage controlled for tuning the resonance frequency of the tuning circuit. The PIN diode is switched on and off by an operating voltage. In case that the PIN diode is switched off, the tuning circuit is operated in a lower frequency band, whereas, in case that the PIN diode is switched on, the tuning circuit is operated in a higher frequency band. In the lower frequency band, the resonance frequency is determined by the capacitance values of the respectively provided capacitors and the inductance values of both of the inductor means connected in series. In the upper frequency band, the resonance frequency is determined by the capacitance values of the respectively provided capacitors and the inductance value of only one of the inductor means. As stated above, at the lower resonance frequency, both of the inductors contribute to the resonance frequency. If the higher resonance frequency is e.g. 1,1 to 1,2 times higher than the lower frequency in the UHF-band in order to obtain a wide band VCO with two resonance frequencies close to each other, the second inductor means, which is parallel to the PIN diode, should have a small inductance value of about 1nH to 2nH whereas the first inductor means should have a larger inductance value of e.g. 10nH. Of course, these values depend on the total capacitance values. Inductor means with a small inductance vale like 1nH do not have good tolerance value. Normally, the tolerance of inductor means is about ± 0,2nH in the case of inductor means with such a small inductance value. The tolerance of the first inductor means is about 2% the case of an inductance value of 10nH. This means, that an inductance tolerance of 2% cannot be achieved in the lower resonance frequency band. If, e. g., the first inductor has an inductance value of 10nH±2% tolerance and the second inductor means has an inductance value of 1nH±0,2nH tolerance, the nominal value for the inductance is 10n+1n=11nH and the maximum value is (10nH+10nHx0,02)+(1nH+0,2nH)=11,4nH, so that the total tolerance value is 3,6%. This means, that it is difficult to optimize both resonance frequencies in the upper and the lower frequency band in this known tuning circuit.

JP-A-07202638 discloses also a voltage controlled tuning circuit which is band switchable between two different frequency bands. A first and a second inductor means are connected in parallel to each other. A voltage controlled variable capacitance diode is provided, whose capacitance is set by a control voltage. The voltage of the control voltage thus determines the resonance frequency of the tuning circuit and the corresponding resonance circuit. The tuning circuit is band switched between two different frequency bands by a band switch connected to the first and the second inductor means. The band switch can be switched to selectively or alternately choose one of the inductor means. The inductor means have different inductance values corresponding to the lower and upper frequency band, respectively. In the tuning circuit disclosed in JP-A-07202638, the band switch for selectively choosing one of the inductor means is an integral part of the portion of the tuning circuit determining the resonance frequency. The electrical switch used as the band switch usually does not have good enough high frequency characteristics, e. g. a good enough high frequency response. Thus, the disclosed tuning circuit does not have a good performance in the UHF- or VHF- band, which are the frequency bands of interest in the present case. Electrical switches with good high frequency characteristics exist, but are very expensive.

Therefore, the object of the present invention is to provide a voltage controlled tuning circuit which is band switchable between two or more different frequency bands, which is less sensible in view of the tolerance values of the inductor means than the tuning circuits of the prior art. Another object of the present invention is to provide a tuning circuit which is band switchable between two or more different UHF- or VHF- frequency bands and which can be manufactured at lower costs.

This object is achieved by a voltage controlled tuning circuit for tuning a resonance frequency of an oscillator according to claim 1, which comprises a voltage controlled variable capacitance means, a first and second inductor means connected in parallel to each other and parallel to the variable capacitance means, and a first band switch means for the first inductor means and a second band switch means for the second inductor means for band switching the resonance frequency.

Since each of the two inductor means has a respectively allocated band switch means, the tuning circuit according to the present invention can be arranged and band switched in a way that the high frequency characteristics of the band switch means do not affect the performance of the tuning circuit. Particularly, the first and the second band switch means can be controlled by a separate switching means, which is connected to but not part of the tuning circuit determining the resonance frequency. Therefore, the high frequency characteristics of the switching means do not affect the performance of the tuning circuit. The switching means can therefore be a simple and inexpensive electrical switch, which selectively or alternately switches the first and the second band switch means on and off. In a particular advantageous embodiment the first and the second switch means are PIN diodes, which are connected in series to the first and the second inductor means. In this case, the switch means alternatively supplies an operating voltage to the respectively choosen PIN diode, to switch the respective PIN diode on, so that the respectively allocated inductor means contributes to the generation of the resonance frequency.

In the tuning circuit according to the present invention, the resonance frequency thus depends in the lower as well as in the upper frequency band only on the respective capacitance values of the respectively provided capacitors and the inductance value of the respective inductor means. The inductance value of the respectively unused inductor means does not contribute to the resonance frequency value of the tuning circuit in both of the frequency bands. It is therefore possible to tune the resonance frequency independent from the inductance value of the inductor means for the respectively other frequency band. Further on, the tuning circuit according to the present invention can be manufactured at low cost, since one band switch means is respectively provided for each inductor means and the two band switch means can be controlled by a common separate switch means, which is not part of the tuning circuit determining the resonance frequency. In other words, the resonance frequency is independent from the high frequency characteristics of the switch means alternately switching the first and the second band switch means. Therefore, the voltage controlled tuning circuit according to the present invention can be manufactured at low cost.

Preferred embodiments of the present invention are explained in detail in the following description relating to the enclosed drawings, in which

fig. 1 shows a first embodiment of a voltage controlled tuning circuit according to the present invention, and
fig. 2 shows a second embodiment of a voltage controlled tuning circuit according to the present invention.

In the drawings, a first and a second embodiment of a voltage controlled tuning circuit according to the present invention are shown in combination with a respective resonance circuit. However, the voltage controlled tuning quit according to the present invention could be used with other oscillators, e.g. a quartz oscillator circuit.

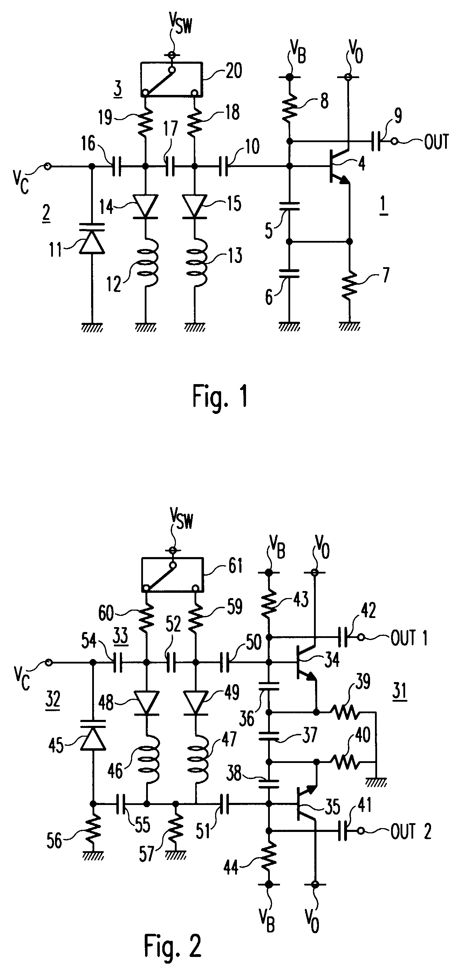

Fig. 1 shows a first embodiment of a voltage controlled oscillator comprising a resonance circuit 1 and a voltage controlled tuning circuit 2. The resonance circuit 1 comprises a transistor 4. The emitter of the transistor 4 is grounded via a resistor 7. The base and the emitter of the resistor 4 are connected via a capacitor 5. The capacitor 5 is connected in series with a grounded capacitor 6. The base of the transistor 4 is thereby connected with an intermediate point between the capacitor 5 and the capacitor 6, so that the capacitor 5 and the capacitor 6 form a voltage divider. The base of the transistor 4 is biased by a bias voltage $V_B$ via a resistor 8. An output terminal OUT is connected via capacitor 9 to the base of the transistor 4. The collector of the resistor 4 is operated by an operating voltage $V_O$. Thus the basic structure of the resonance circuit shown in fig. 1 is a common emitter connection of the transistor 4.

The resonance circuit 1 is connected via a capacitor 10 to the tuning circuit 2. The tuning circuit is controlled by a voltage $V_C$, which is a DC voltage and defines the capacitance of a variable capacitance diode 11. The variable capacitance diode 11 is grounded. The first inductor 12 and the second inductor 13 are connected in parallel with each other. The first inductor 12 and the second inductor 13 are both grounded. The first inductor 12 and the second inductor 13 connected in parallel to each other are also connected in parallel to the variable capacitance diode 11. The first inductor 12 is connected in series to a PIN diode 14 and the second inductor 13 is connected in series to a PIN diode 15. The PIN diode 14 is connected to the side of the inductor 12, which is not grounded. The PIN diode 15 is connected to the side of the inductor 13, which is not grounded. The PIN diode 14 forms the first band switch means for the first inductor 12 and the PIN diode 15 forms a second band switch means for the second inductor 13. Between the PIN diode 14 and the PIN diode 15, a capacitance 17 is provided, which serves for cutting of DC components. A capacitor 16 is provided between the PIN diode 14 and the variable capacitance diode 11. The capacitor 16 is also connected to the terminal for the control voltage $V_C$.

The PIN diode 14 and the PIN diode 15 are both connected to a common switch 20, which selectively and alternately connects one of the PIN diodes 14, 15 to a switch voltage $V_{SW}$.

The switch 20 is part of a switch means 3 comprising also two resistors 18, 19. The switch means 3 is connected to but not part of the tuning circuit determining the resonance frequency. In the embodiment shown in fig. 1, the switch 20 is an electrical switch, which connects one of the PIN diodes 14 or 15 via a respective resistor 18 and 19 to the switch voltage. The resistor 18 is thereby connected in series to the PIN diode 15, whereas the resistor 19 is connected in series to the PIN diode 14. In the case shown in fig. 1, the switch 20 is switched to a position, in which the PIN diode 14 is connected via its resistor 19 to the switch voltage $V_{SW}$. The switch voltage $V_{SW}$ is high enough to switch the PIN diode 14 on, so that the first inductor 12 contributes to and determines the resonance frequency of the tuning circuit and the resonance circuit.

The resonance frequency in this case is determined by the following equation:

$$F_1 = \frac{1}{2\pi\sqrt{C_{f1} \cdot L_1}}$$

wherein $L_1$ is the inductance of the first inductor 12 and $C_{f1}$ is the total capacitance of the capacitors contained in the oscillator circuit comprising the resonance circuit 1 and the tuning circuit 2, as shown in fig. 1. The total capacitance $C_{f1}$ is defined by the following equation:

$$C_{f1} = \frac{C_V \cdot C_{16}}{C_V + C_{16}} + \frac{C_{17} \cdot C_{10} \cdot C_5 \cdot C_6}{C_{17} \cdot C_{10} \cdot C_5 + C_{17} \cdot C_{10} \cdot C_6 + C_{17} \cdot C_5 \cdot C_6 + C_{10} \cdot C_5 \cdot C_6}$$

wherein $C_V$ is the capacitance of the variable capacitance diode 11, $C_{16}$ is the capacitance of the capacitor 16 for cutting of DC components, $C_{17}$ is the capacitance of the capacitor 17 for cutting of DC components, $C_{10}$ is the capacitance of the capacitor 10 connecting the resonance circuit 1 and the tuning circuit 2, $C_5$ is the capacitance of the capacitor 5 connecting the base and the emitter of the transistor 4 and $C_6$ is the capacitance of the capacitor 6 connecting the emitter of the transistor 4 with ground.

In case that the switch 20 is switched to a position, in which it supplies the switch voltage $V_{SW}$ to the PIN diode 15, the PIN diode 15 is switched on and the resonance frequency of the tuning circuit and the resonance circuit is determined by the inductance $L_2$ of the second inductor 13. Preferably, the threshold voltage for switching on the PIN diode 15 has the same value as the threshold value for switching on the PIN diode 14. In other words, the PIN diode 14 and the PIN diode 15 preferably are identical elements. Assuming that the inductance $L_2$ of the second inductor 13 is larger than the inductance $L_1$ of the first inductor 12, the PIN diode 14 is switched on if the tuning circuit is to be operated in the higher frequency band, and the PIN diode 15 is switched on, if the tuning circuit is to be operated in the lower frequency bid.

The resonance frequency of the voltage controlled oscillator circuit shown in fig. 1 in the case that the switch 20 is switched to the not shown position, in which the PIN diode 15 is switched on, the resonance frequency $F_2$ is determined by the inductance $L_2$ of the second inductor 13:

$$F_2 = \frac{1}{2\pi\sqrt{C_{f2} \cdot L_2}}$$

wherein $L_2$ is the inductance of the second inductor 13 and $C_{f2}$ is the total capacitance of the capacitors contained in the oscillator circuit comprising the resonance circuit 1 and the tuning circuit 2. The total capacitance is determined by the following equation:

$$C_{f2} = \frac{C_V \cdot C_{16} \cdot C_{17}}{C_V \cdot C_{16} + C_V \cdot C_{17} + C_{16} \cdot C_{17}} + \frac{C_{10} \cdot C_5 \cdot C_6}{C_{10} \cdot C_5 + C_{10} \cdot C_6 + C_5 \cdot C_6}$$

wherein $C_V$ is the capacitance of the variable capacitance diode 11, $C_{16}$ is the capacitance of the capacitor 16, $C_{17}$ is the capacitance of the capacitor 17, $C_{10}$ is the capacitance of the capacitor 10, $C_5$ is the capacitance of the capacitor 5 and $C_6$ is the capacitance of the capacitor 6.

Therefore, in each frequency band, the resonance frequency is only determined by the total capacitance of the capacitors contained in the oscillator circuit and the inductance value of the respective inductor. The inductance value of the not used other inductor does not contribute to the resonance frequency value. Therefore, the tuning circuit according to the present invention is much less tolerance sensible than known tuning circuits.

In fig. 2, an oscillator circuit comprising a resonance circuit 31 in the tuning circuit 32 according to a second embodiment of the present invention is shown. The only functional difference between the oscillator circuit shown in fig.1 and the oscillator circuit shown in fig. 2 is that the oscillator circuit shown in fig. 2 provides the output oscillation signal differentially on two output terminals OUT 1 and OUT 2. The structure of the oscillator circuit shown in fig. 2 is particularly useful for implementation as an integrated circuit.

The resonance circuit 31 comprises a first transistor 34 and a second transistor 35. The emitter of the transistor 34 is grounded via a resistor 39 and the emitter of the transistor 35 is grounded via a resistor 40. The emitter of the transistor 34 is connected via a capacitor 36 to the base of the transistor 34. Similarly, the emitter of the transistor 35 is connected to the base of the transistor 35 via a capacitor 38. The base of the transistor 34 is connected via a capacitor 42 to a first output terminal OUT 1. The base of the second transistor 35 is connected via the capacitor 41 to the second output terminal OUT 2. The base of the transistor 34 is biased via a resistor 43 by a bias voltage $V_B$. The base of the transistor 35 is biased via a resistor 44 by a bias voltage $V_B$. The collector of the transistor 34 is connected to and operated by an operating voltage $V_O$. The collector of the transistor 35 is connected to and operated by an operating voltage $V_O$. The transistor 34 and the transistor 35 could also be operated by the same operating voltage. Similarly, the transistor 34 and the transistor 35 could be biased by same bias voltage. The capacitor 36 and the capacitor 38 are connected in series, whereby the capacitor 37 is connected between them so that a voltage-divider is formed. Thus and as can be seen from figure 2, the basic structure of the resonance circuit 31 is a common emitter connection.

The base of the transistor 34 is connected to a capacitor 50 and the base of the transistor 35 is connected to a capacitor 51. The capacitors 50 and 51 form the connection of the resonance circuit 31 to the tuning circuit 32. The capacitor 50 and the capacitor 51 thereby serve to cut off DC components.

The tuning circuit 32 comprises a variable capacitance diode 45, the capacitance of which is controlled by a control voltage $V_C$. The first inductor 46 and the second inductor 47 are connected in parallel with each other and parallel to the variable capacitance diode 45. A PIN diode 48 serving as a first band switch is connected in series to the first inductor 46 and a PIN diode 49 serving as a second band switch is connected in series to the second inductor 47. The side of the first inductor 46 not connected to the PIN diode 48 is grounded via a resistor 57. The side of the second inductor 47 not connected to the PIN diode 49 is grounded via the same resistor 57. The PIN diode 45 is grounded via resistor 56 on the side opposite to the terminal for supplying the control voltage $V_C$. The PIN diode 45 and the first inductor 46 are connected by a capacitor 55 on their grounded sides. Further on, the variable capacitance diode 45 and the PIN diode 48 are connected by a capacitor 54. The PIN diode 48 and the PIN diode 49 are connected by a capacitor 52 on their sides opposite to the first inductor 46 and the second inductor 47, respectively. The capacitor 52 is also connected to the capacitor 50 and the capacitor 53 is also connected to the capacitor 51.

The PIN diode 48 and the PIN diode 49 are connected to a switch 61, which supplies alternately and selectively a switch voltage $V_{SW}$ to the PIN diode 48 and the PIN diode 49, via a resistor 60 and a resistor 59, respectively. The resistor 60 is connected in series between the switch 61 and the PIN diode 48 and the resistor 59 is connected in series between the switch 61 and the PIN diode 49. The switch 61, the resistor 60 and the resistor 59 form a switch means 33. The function and the way of operation of the switch 61 and the PIN diode 48 and the PIN diode 49 of the second embodiment shown in figure 2 are the same as the function and the way of operation of the switch 20, the PIN diode 14 and the PIN diode 15 of the first embodiment shown in fig.1, so that the corresponding description is omitted. Preferably, the PIN diode 48 and the PIN diode 49 are identical elements, so that they can be switched on by the same value of the switch voltage $V_{SW}$. In the position of the switch 61 shown in fig. 2, the PIN diode 48 is switched on by the switch voltage $V_{SW}$, so that the inductance $L_1$ of the first inductor 46 contributes to the resonance frequency of the oscillator circuit. In the other position of the switch 61 not shown in fig. 2, the PIN diode 49 is switched on by the switch voltage $V_{SW}$ and only the inductance $L_2$ of the second inductor 47 contributes to the resonance frequency of the oscillator circuit. As in the first embodiment, also in the second embodiment only the inductance value of the respective inductor choosen for the respective frequency band contributes to the resonance frequency. The inductance value of the respective other inductor does not contribute to the resonance frequency.

The equations given above for the resonance frequencies $f_1$ ad $f_2$ for the upper and the lower frequency band are also true for the second embodiment. However, the total capacitance $C_{f1}$, $C_{f2}$ in the second embodiment are slightly different, since the capacitance values of the capacitors 55, 53, 51 and 38 also contribute to the total capacitance values $C_{f1}$ and $C_{f2}$.

Although the tuning circuits of the first and second embodiment explained above are band switchable between to frequency bands, they could also be switchable between three or more frequency bands. In this case, an additional inductor means for each additional frequency band has to be provided in the tuning circuit and the switch means has to be adopted correspondingly.

## Claims

1. Voltage controlled tuning circuit for tuning a resonance frequency of an oscillator, comprising

    a voltage controlled variable capacitance means (11; 45),
    a first and a second inductor means (12, 13; 46, 47) connected in parallel to each other and parallel to the variable capacitance means (11; 45), and
    a first band switch means (14; 48) for the first inductor means (12; 46) and a second band switch means (15; 49) for the second inductor means (13; 47) for band switching the resonance frequency.

2. Voltage controlled tuning circuit according to claim 1,
    **characterized by**

a first switching means (20; 61) for alternately on/off- switching the first and second band switch means (14, 15; 48, 49).

3. Voltage controlled tuning circuit according to claim 1 or 2,
   **characterized in**,

   that the first and the second band switch means (14, 15; 48, 49) are PIN diodes connected in series to the first and second inductor means (12, 13; 46, 47).

4. Voltage controlled tuning circuit according to claim 3,
   **characterized in,**

   that the switch means (20; 61) is alternately supplying a switch voltage to the PIN diodes (14, 15; 48, 49).

Fig. 1

Fig. 2

**European Patent Office**

## EUROPEAN SEARCH REPORT

Application Number

EP 98 10 5337

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 008, no. 107 (E-245), 19 May 1984 & JP 59 022404 A (HITACHI DENSHI KK;OTHERS: 01), 4 February 1984 * abstract * | 1-4 | H03J1/00 H03J5/24 H03B5/12 |
| X | US 4 271 529 A (STRAMMELLO JR PETER) 2 June 1981 * column 1, line 41 - line 43 * * column 3, line 36 - column 4, line 55 * | 1,2 | |
| A | FR 2 612 017 A (AEROSPATIALE) 9 September 1988 * the whole document * | 1-4 | |
| D,A | PATENT ABSTRACTS OF JAPAN vol. 095, no. 011, 26 December 1995 & JP 07 202638 A (MATSUSHITA ELECTRIC IND CO LTD), 4 August 1995 * abstract * | 1 | |
| | | | TECHNICAL FIELDS SEARCHED (Int.Cl.6) |
| | | | H03J H03B |

The present search report has been drawn up for all claims

| Place of search | Date of completion of the search | Examiner |
|---|---|---|
| THE HAGUE | 14 August 1998 | Peeters, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)